(19) Europäisches Patentamt
European Patent Office
Office européen des brevets

(11) **EP 1 830 419 B1**

(12) **EUROPÄISCHE PATENTSCHRIFT**

(45) Veröffentlichungstag und Bekanntmachung des Hinweises auf die Patenterteilung:
**01.07.2009 Patentblatt 2009/27**

(51) Int Cl.:
***H01L 39/16*** *(2006.01)*

(21) Anmeldenummer: **06004214.0**

(22) Anmeldetag: **02.03.2006**

(54) **Resistiver Strombegrenzer**

Resistive Current Limiter

Limiteur de courant résistant

(84) Benannte Vertragsstaaten:
**AT BE BG CH CY CZ DE DK EE ES FI FR GB GR HU IE IS IT LI LT LU LV MC NL PL PT RO SE SI SK TR**

(43) Veröffentlichungstag der Anmeldung:
**05.09.2007 Patentblatt 2007/36**

(73) Patentinhaber: **Theva Dünnschichttechnik GmbH 85737 Ismaning (DE)**

(72) Erfinder:
• **Kinder, Helmut Prof. Dr.
85354 Freising (DE)**
• **Prusseit , Dr. Werner
80799 München (DE)**

(74) Vertreter: **Hess, Peter K. G.
Patent- und Rechtsanwälte
Bardehle . Pagenberg . Dost .
Altenburg . Geissler
Postfach 86 06 20
81633 München (DE)**

(56) Entgegenhaltungen:
**EP-A- 1 217 666          EP-A- 1 217 708
EP-A2- 0 385 485         EP-A2- 0 444 702
EP-A2- 0 503 448         EP-A2- 1 052 707
WO-A2-20/04006345    DE-A1- 10 142 870
DE-C1- 4 434 819**

• **NOE ET AL: "SUPRALEITENDE STROMBEGRENZER IN DER ENERGIETECHNIK" ELEKTRIE, VERLAG TECHNIK. BERLIN, DE, Bd. 51, Nr. 11/12, 1997, Seiten 414-424, XP000869316 ISSN: 0013-5399**

EP 1 830 419 B1

**Beschreibung**

**1. Technisches Gebiet**

Die Erfindung bezieht sich auf einen supraleitenden resistiven Fehlerstrombegrenzer.

**2. Der Stand der Technik**

Supraleitende Fehlerstrombegrenzer (FSB) sollen dem Schutz von elektrischen Anlagen und Stromnetzen vor Überlastung dienen. Die Funktion eines supraleitenden FSB ist sehr einfach. Im Nennstrombetrieb ist der Leiter im supraleitenden Zustand und daher verlustlos. Bei Überlast schaltet der Supraleiter ab einem bestimmten Schwellenwert sehr schnell in den normalleitenden Zustand und hat dann einen hohen ohmschen Widerstand, der den Strom auf ein unschädliches Maß reduziert.

Der Vorteil der supraleitenden FSB gegenüber konventionellen mechanischen Schaltern ist ihre sehr viel kürzere Ansprechzeit. Andererseits entwickeln sie im normalleitenden Zustand erhebliche Wärmemengen, so dass sie die Begrenzungswirkung nur für einige 10 Millisekunden aufrechterhalten können. Daher muss immer ein konventioneller mechanischer Schalter in Serie geschaltet werden, der den Strom nach seiner längeren Schaltzeit (typisch 50-100 ms) endgültig unterbricht. Anschließend kann der Supraleiter wieder zurückkühlen und ist wieder einsatzbereit. Eine entsprechende Anordnung ist zum Beispiel aus der DE 199 39066 bekannt.

Da die Hochtemperatursupraleiter (HTS) als keramische Materialien im normalleitenden Zustand besonders hochohmig sind, eignen sie sich bestens für diese Anwendung. Daher wird schon seit ihrer Entdeckung im Jahr 1986 intensiv an ihrem Einsatz als FSB in der Energietechnik gearbeitet. Heute gehören zum Stand der Technik induktive Strombegrenzer und resistive Strombegrenzer. Dabei sind die resistiven auf Grund der deutlich geringeren Investitions- und vor allem auch Betriebskosten vorteilhafter. Resistive Strombegrenzer wurden entweder aus keramischem Vollmaterial oder aus Dünnfilmen auf isolierendem Substrat, wie z.B. in DE 198 27225 beschrieben, hergestellt. In beiden Fällen stehen noch Materialprobleme und Kostengründe einer kommerziellen Nutzung im Wege. Daher konnte noch kein Typ zur Marktreife gebracht werden.

Inzwischen ist jedoch ein neuer Typ eines HTS-Leiters verfügbar, beschichtete Metallbänder oder "coated conductors" (CC). Dabei handelt es sich um ein dünnes Trägerband aus normalleitendem Metall, auf dem neben einer Reihe von Zwischenschichten eine HTS-Schicht von typisch einigen $\mu$m, grundsätzlich aber bis zu einigen 10 $\mu$m Dicke aufgebracht wird. Das eigentlich spröde keramische Supraleitermaterial bleibt in Form dieser dünnen Schichten elastisch und biegsam, und es kann besonders hohe Stromdichten tragen. Zudem können CC relativ kostengünstig hergestellt werden. Damit sind neue Möglichkeiten für den Aufbau von FSBs gegeben, die zu einer wirklichen Marktreife und kommerziellen Nutzung führen können.

Wesentlicher Unterschied zu den bisherigen Bautypen ist das metallisch leitende Trägerband oder Substrat. Auch bei Verwendung hochohmiger Legierungen wie Hastelloy® oder Constantan bleibt der Gesamtwiderstand des Bandes sehr deutlich unter dem der Supraleiterschicht allein. Daher müssen große Bandlängen verwendet werden, um einen hinreichend hohen Widerstand für das Schalten von Hochspannung zu erzielen. Beispielsweise werden für eine Spannung von 20 kV mindestens 100 m Bandlänge benötigt. Die Bänder müssen also in geeigneter Weise angeordnet und montiert werden, um kompakte Bauelemente zu ergeben.

Ein weiterer Unterschied zu den bisherigen Bautypen ist die Flexibilität des dünnen Trägerbandes, das neue Techniken der Halterung erfordert. Aufgrund des Metallsubstrats, seiner Flexibilität und der großen Bandlänge ergeben sich technische Probleme, die für die CC-FSBs spezifisch sind. Als nach dem Stand der Technik gelöst können folgende Probleme gelten:

- Elektrischer Durchschlag zum Substrat:

  Die Supraleiterschicht ist von dem metallischen Trägerband aus konstruktiven Gründen meistens durch eine oder mehrere elektrisch isolierende Zwischenschichten getrennt. Während des Schaltvorganges in den normalleitenden Zustand treten lokal sehr hohe Spannungsabfälle auf, die große Potenzialdifferenzen zwischen Supraleiter und Substrat zur Folge haben und damit zum dielektrischen Durchbruch der sehr dünnen isolierenden Zwischenschicht führen. Zwischen HTS - Schicht und Metallsubstrat muss deshalb auf geeignete Weise für einen fortlaufenden Potenzialausgleich gesorgt werden. Um im Falle eines Schaltvorgangs dem Strom einen Übertritt ins metallische Substratband zu ermöglichen, wurden z.B. in DE 19836860, EP 1 042 820, oder DE 10225935 eine ganze Reihe verschiedener fortlaufender oder punktueller Kontaktanordnungen beschrieben.

- "Hot Spots":

Die Schaltschwelle des Supraleiters hängt ab von der kritischen Stromstärke desselben. Dies ist eine Materialeigenschaft, die von Ort zu Ort schwanken kann, üblicherweise um 20 bis 50%. Daher ist die Schaltschwelle an Schwachstellen mit niedrigerem kritischem Strom früher erreicht als im übrigen Leiter. Beim Ansteigen des Überstroms werden diese Stellen zuerst normalleitend und entwickeln Widerstand. Da die Stellen aber örtlich begrenzt sind, reicht der Widerstand nicht aus, um den Strom merklich zu begrenzen. Damit überhitzen sich diese "Hot Spots" und werden zerstört, noch bevor das übrige Material normalleitend werden kann. Solche Hot Spots können auch bei anderen FSB-Typen auftreten. Spezifisch bei CC-basierten FSB lassen sie sich aber nach dem Stand der Technik vermeiden, wie in DE 10225935 beschrieben.

- Maximale Deformation:

Das keramische Material der Hochtemperatursupraleiter ist empfindlich gegen zu starke Deformationen. Bekanntermaßen treten erste Degradationen, vermutlich auf Grund von Mikrorissen, ab einer Dehnung von ca. 0,2% ein. Dies bedingt einen minimalen Krümmungsradius, der von der Dicke des Bandes abhängt gemäß

$$R_{min} = \frac{d}{2\varepsilon_{max}}$$ Dabei ist d die Banddicke und $\varepsilon_{max}$ die maximale Dehnung. Beispielsweise beträgt der minimale Krümmungsradius bei einer Banddicke von 100 $\mu$m etwa 25 mm, der bei allen Konstruktionen eingehalten werden muss. Da der Hochtemperatursupraleiter gegen Stauchung weniger empfindlich ist als gegen Dehnung, liegt die Supraleiterschicht bevorzugt auf der Innenseite einer Bandkrümmung.

WO 2004/006345 A2 offenbart eine Strombegrenzereinheit, die einen Leiter mit einer Supraleitschicht zur resistiven Begrenzung eines elektrischen Stromes aufweist sowie einen mit einem aus einem Isolierstoff bestehenden Tragkörper zum Halten eines Leiters, wobei der Leiter sich zwischen Stromanschlüssen zum Zu- und Abführen des Stromes erstreckt. Die Strombegrenzereinheit umfasst Windungen, die in Form einer bifilaren Leiterstruktur ausgebildet sind, so dass in benachbarten Windungen ein zu begrenzender Strom gegensinnig fließt, wodurch sich das Magnetfeld der benachbarten Windungen weitgehend kompensiert.

EP 0 503 448 A2 beschreibt einen supraleitenden Strombegrenzer mit einem den Nennstrom tragenden Leiter, der zumindest teilweise aus supraleitendem Material gefertigt wird. Der Strombegrenzer umfasst einen bandförmigen Leiter, der durch eine metallische Schicht begrenzt wird. Der Leiter wird als bifilare Spule aufgewickelt und in einer für strömende Medien durchlässigen Halterung dauerhaft so angeordnet, dass seine Enden elektrisch leitend mit einem weiteren supraleitenden Strombegrenzer in Serie oder parallel geschaltet werden können.

EP 0 444 702 A2 offenbart einen vergüteten Supraleiter, der zu einer supraleitenden Spule aufgewickelt wird und sich aus einem äußeren normalleitenden und einem inneren supraleitenden Material zusammensetzt. Zusätzlich weist der Supraleiter eine auf dem normalleitenden Material liegende Harzschicht auf.

EP 0 385 485 A2 präsentiert einen Hochtemperaturoxydsupraleiter, der bei der Temperatur des flüssigen Stickstoffs eine große kritische Stromdichte in einen großen Magnetfeld aufweist. Die Oxydkristalle sind in einer bestimmten Richtung orientiert, so dass der Hochtemperaturoxydsupraleiter frei von nichtsupraleitenden oder schwach supraleitenden Phasen ist, die für die Supraleitung in den Körnern nachteilig ist.

Nach dem Stand der Technik noch ungelöst sind Probleme, die mit der Anordnung und der Montage der Bänder zusammenhängen:

- Gasentwicklung:

Die starke Wärmeentwicklung der normalleitenden Bereiche führt zu sehr heftigem Verdampfen des Kühlmittels, z. B. flüssigem Stickstoff oder anderer Kryoflüssigkeiten. Durch die Blasenbildung wirken erhebliche Kräfte auf das Band, die zu Verbiegen und Bruch des Supraleiters und zur gegenseitigen Berührung verschiedener Bandabschnitte mit Kurzschlüssen führen kann. Die in EP 1 217 666 beschriebenen Schwingungsdämpfer zwischen plattenförmigen Modulen stellen keine Lösung im Falle der langen CC-Bänder dar.

- Wärmeausdehnung:

Durch die Erwärmung der normalleitenden Bereiche dehnt sich der CC in Längsrichtung aus. Zudem bewirken Temperaturunterschiede zwischen Vorder- und Rückseite des Bandes eine Verbiegung desselben, ähnlich einem Bimetall (thermische Formänderung). Dabei können große Kräfte wirken, wenn das Band ungünstig montiert ist. Die Folge ist ein Bruch des Supraleiters und die gegenseitige Berührung verschiedener Bandabschnitte mit Kurzschlüssen.

- Magnetische Kräfte:

  Da das Band von Strom durchflossen ist, üben die verschiedenen Bandabschnitte gegeneinander magnetische Kräfte aus. Die Kräfte wachsen quadratisch mit dem Strom. Da es sich um Wechselstrom handelt, kann das Band bei ungünstiger Montage zu Vibrationen angeregt werden. Besonders groß werden die Kräfte, wenn der Kurzschlussstrom ansteigt. Dann ergeben sich die gleichen Probleme wie beim Verdampfen und der Wärmeausdehnung.

- Überhitzung bei gehindertem Kühlmittelzutritt zum CC:

  Werden auch nur kurze Stücke des Bandes durch Montageteile abgedeckt, so kann dort die Kühlflüssigkeit nicht mehr ungehindert zutreten. Dies bedeutet, dass sich solche Stellen schneller aufheizen. Dort bilden sich im Kurzzeitverhalten (einige Millisekunden) zwar keine Hot Spots, aber das Langzeitverhalten (einige 10 ms) ist entscheidend beeinträchtigt: Solche Stellen wärmen sich besonders schnell auf und brennen durch, noch ehe der in Serie liegende mechanische Schalter ansprechen konnte. Entsprechendes gilt für Spulen, bei denen Lage auf Lage gewickelt wird. Auch hier wird der Kühlmittelzutritt gehindert. Auch gewellte Abstandshalter, wie in (EP 1042820) beschrieben, führen zur Behinderung des Kühlmittelzutritts an den Auflagestellen.

- Dielektrischer Durchbruch des Kühlmittels

  Da die FSBs in Hochspannungsnetzen eingesetzt werden, müssen elektrische Durchschläge, Überschläge und Teilentladungen sicher verhindert werden. Zwar besitzt z.B. flüssiger Stickstoff eine sehr hohe Durchschlagfestigkeit, jedoch wird diese durch Gasblasen stark herabgesetzt. Daher besteht gerade beim Schalten, wenn das Kühlmittel siedet, die Gefahr von Durchschlägen zwischen Teilen auf verschiedenem Potenzial.

- Abnahme des Kritischen Stroms im Eigenmagnetfeld

  Die kritische Stromstärke der Supraleiter nimmt im Magnetfeld ab. Bei ungünstigem Aufbau des FSB kann der zu begrenzende Strom selbst ein hinreichend starkes Feld erzeugen, so dass die Schaltschwelle des FSB merklich erniedrigt wird und somit die Schaltleistung geringer wird. Als Gegenmaßnahme für Strombegrenzer aus sog. BSCCO-Bandleiter wurden nach dem Stand der Technik bifilare Anordnungen vorgeschlagen (EP 1042820, DE 19720397 oder EP 0935261).

- mangelnde mechanische Stabilität:

  Das Band ist flexibel und besitzt somit keine mechanische Stabilität. Trotzdem muss der Aufbau den oben beschriebenen Kräften standhalten können so dass der Aufbau möglichst über Jahrzehnte störungsfrei und zuverlässig arbeitet.

Der vorliegenden Erfindung liegt somit das Problem zugrunde, für den Aufbau eines FSB aus CC Konstruktionsmerkmale und Anordnungen zu finden, mit denen zumindest einige der oben genannten Schwierigkeiten im Betrieb des FSB verringert werden.

**3. Zusammenfassung der Erfindung**

Gemäß eines ersten Aspekts betrifft die vorliegende Erfindung wie durch Anspruch 1 definiert einen Strombegrenzer mit einem Bandleiter, der mit einem Hochtemperatursupraleiter beschichtet ist, und mit zumindest einem Montageelement, das den Bandleiter im Wesentlichen ausschließlich an einem oder mehreren Randbereichen hält, so dass der Bandleiter das Montageelement nicht flächig kontaktieren kann. Das zumindest eine Montageelement des erfindungsgemäßen Strombegrenzers ist notwendig, um lange Bänder in die Form von kompakten Komponenten zu bringen Um freien Kühlmittelzutritt zum Supraleiter zu gewährleisten, dürfen die Montageelemente das Band aber im Wesentlichen nur am Rand berühren.

Das Montageelement umfasst eine Hohlform, in der sich der Bandleiter erstreckt. Da der Bandleiter eine genügende Steifigkeit in Querrichtung besitzt, kann er sich dann nicht flächig an die Hohlform anlegen, sondern nur mit seinen Rändern. Bevorzugt weist die Hohlform des Montageelements auf einer dem Bandleiter zugewandten Seite einen zumindest abschnittsweise konkaven Querschnitt auf. Vorzugsweise weist der Bandleiter eine Breite d auf und die Hohlform einen mittleren Krümmungsradius r mit $0{,}5d \leq r \leq 10d$, besonders bevorzugt $0{,}6\,d \leq r \leq 4d$. In einem Ausführungsbeispiel ist dazu das Montageelement als ein rundes oder ovales Rohr ausgebildet, durch das sich zumindest ein Abschnitt des Bandleiters erstreckt.

Vorzugsweise werden nur kurze Hohlformen verwendet, zwischen denen das Band jeweils eine Strecke weit freitragend verläuft. Besonders bevorzugte kurze Hohlformen sind quer zum Band stehende dünne Platten oder Folien mit runden bzw. ovalen Bohrungen bzw. Öffnungen, in die das Band eingeschoben wird. Dann kann das Band der Einwirkung der Kräfte durch Blasenbildung, Wärmeausdehnung, und Magnetfelder ausweichen, ohne abzuknicken, wodurch es zerstört würde.

In einem weiteren Ausführungsbeispiel wird der Bandleiter durch das Montageelement in seinen Randbereichen mit einem Spiel gehalten, das vorzugsweise zwischen 5% und 50% und besonders bevorzugt zwischen 10% und 30% der Breite d des Bandleiters beträgt. Damit erhält das Band eine kontrollierte Bewegungsfreiheit. In einem anderen Ausführungsbeispiel weist das Montageelement eine federnde Passung für den Bandleiter auf.

Als Material für die Montageelemente zur Halterung des Bandes am Rand kommen bevorzugt isolierende Stoffe in Frage, wie einfacher Kunststoff, glasfaserverstärkter Kunststoff (GFK), Polyimid oder Keramik. Kurze Montageelemente können aber auch aus Metall sein, da entlang kurzer Strecken kein nennenswerter Spannungsabfall auftritt.

Ein außerhalb der vorliegenden Erfindung befindliches Beispiel betrifft einen Strombegrenzer mit einem Bandleiter, der mit einem Hochtemperatursupraleiter beschichtet ist, und mit zumindest einem Montageelement, das den Bandleiter auf einer oder beiden Hauptflächen (Vorder- oder Rückseite) elektrisch leitend kontaktiert, so dass der Bandleiter in normalleitendem Zustand durch das Montageelement im Kontaktbereich elektrisch überbrückt wird.

Eine zuverlässige Befestigung des Bandleiters ohne Spiel erfordert eine Halterung an der Hauptfläche. An dieser Stelle ist der Zutritt des Kühlmittels behindert. Damit der Bandleiters sich dennoch nicht unzulässig erhitzt, muss die Wärmeentwicklung an der Berührfläche reduziert werden. Dies lässt sich dadurch realisieren, dass der Bandleiter an der Berührfläche durch das Montageelement elektrisch überbrückt wird. Dazu muss das Montageelement an der Berührfläche aus elektrisch leitfähigem Material bestehen und in gutem elektrischen Kontakt mit dem Band stehen. Durch die Überbrückung sinkt der Strom des normalleitenden Bandes im Bereich der Berührfläche. Dadurch sinkt die Leistung und damit die Wärmeentwicklung im Band. Die verbleibende Wärme kann durch den Wärmekontakt zum Montageelement abgeführt werden. Daher sollte das Montageelement vorzugsweise genügend Wärmekapazität und genügend Wärmekontakt zum Bandleiter haben, so dass eine Überhitzung des Bandleiters an der Berührfläche vermieden wird.

Der elektrische Widerstand $R_b$ der Überbrückung sollte mit dem Normalwiderstand $R_t$ des Bandleiters auf der Länge der Berührfläche in Beziehung stehen. In einer bevorzugten Ausführung ist $R_b \leq R_t$. Dann ist der Strom im Bandleiter mindestens halbiert und die Wärmeentwicklung geviertelt. In einer besonders bevorzugten Ausführung ist $R_b \leq 0.5R_t$. Dann fließt noch weniger als ein Drittel des Stroms durch das Band und die Wärmeentwicklung ist um den Faktor 9 reduziert. Daher genügt jede metallisch leitende Folie von der Dicke des Bandleiters als leitendes Teil des Montageelements, das auf dem Bandleiter aufliegt.

Es ist auch vorteilhaft, den Kontaktwiderstand $R_c$ zwischen dem Bandleiter und dem Montageelement zu minimieren, da dieser das Band ebenfalls direkt aufheizt. In einer bevorzugten Ausführung ist $R_c \leq 0.2R_t$, und in einer besonders bevorzugten Ausführung $R_c \leq 0.1R_t$. Bei einer gegenwärtig besonders bevorzugten Ausführungsform ist der Kontaktwiderstand $R_c \leq 1 \cdot 10^{-4}$ $\Omega$cm$^2$.

Der Wärmewiderstand wird durch den elektrischen Widerstand gemäß dem Wiedemann-Franz-Lorentz-Gesetz bestimmt. Daher ist er stets ausreichend klein. Die Wärmekapazität $C_m$ des mit dem Band in Kontakt stehenden Teils des Montageelements sollte auf die Wärmekapazität $C_t$ des Bandes in der Kontaktzone bezogen werden. In einer bevorzugten Ausführung ist $C_m \geq C_t$, und in einer besonders bevorzugten Ausführung $C_m \geq 2C_t$.

Es ist weiterhin wichtig, dass der Kontakt zwischen dem Bandleiter und dem Montageelement so ausgeführt wird, dass er sich gut anpasst aber trotzdem die Supraleiterschicht keinen Schaden durch Deformationen oder Kratzer nimmt. Daher besteht das Montageelement in einer bevorzugten Anordnung mindestens aus einer Folie aus weichem Metall, vorzugsweise reinem Indium, Blei oder Kupfer, das an dem Bandleiter anliegt und dessen Dicke bevorzugt gleich der des Bandleiters ist, besonders bevorzugt aber gleich der doppelten Dicke des Bandleiters. Die Folie aus weichem Metall kontaktiert den Bandleiter vorzugsweise auf beiden Hauptflächen. Darüber hinaus ist bevorzugt ein elektrischer Kontakt im Montageelement zwischen den beiden Kontaktflächen vorgesehen. Vorzugsweise wird daher die Folie aus weichem Metall um den Bandleiter gewickelt und dann mit einer isolierenden oder leitenden Klammer befestigt.

Solche kontaktierenden Montageelemente können nicht nur zur Halterung des Bandes sondern auch zu dessen Kontaktierung, z. B. an den Enden zur Stromzuführung, verwendet werden, sowie für eventuell zusätzlich benötigte elektrische Anschlüsse. Sie lassen sich auch zur Reihen- oder Parallelschaltung von zwei oder mehreren Bändern oder Bandabschnitten innerhalb einer Komponente einsetzen. Darüber hinaus können kontaktierende Elemente vorteilhaft auch zur Überbrückung von kleinen Schadstellen des Bandes, etwa Kratzern oder Knicken, verwendet werden, wobei in diesem Fall eine mechanische Verbindung mit der Stützstruktur nicht notwendig ist, sondern auch freitragende Lösungen vorteilhaft sind. Beispielsweise kann die Überdeckung der Stelle mit niedrig schmelzendem Lot oder Leitpaste oder einer leitenden Folie, bevorzugt einer Kupfer- / Indium- / Bleifolie erfolgen.

An der Kante des kontaktierenden Montageelements ist der anschließende Bandabschnitt in der Gefahr, sich mehr als zulässig zu krümmen oder gar abzuknicken, wenn sich das Band beim Schaltvorgang bewegt. Der Kontaktbereich des Montageelements weist daher vorzugsweise zumindest einen abgerundeten Randbereich auf mit einem Krümmungsradius, der größer oder gleich dem minimalen Biegeradius für den Bandleiter ist.

Die Überbrückung von Teilbereichen des Bandleiters führt zu einer Verminderung des Gesamtwiderstandes der Anordnung. Daher sollte die Anzahl dieser Montageelemente nicht zu groß werden. Vorzugsweise sollte das Verhältnis von durch die Kontaktflächen des Montagehalter überbrückter und freier Länge des Bandleiters 1: 5 nicht überschreiten.

Gemäß eines weiteren Aspekts betrifft die vorliegende Erfindung einen Strombegrenzer mit einem Bandleiter gemäß Anspruch 1, der mit einem Hochtemperatursupraleiter beschichtet ist, wobei der Bandleiter eine Konfiguration einnimmt, die einen Mindestabstand zwischen den einzelnen Bandabschnitten und zu sonstigen Montageteilen einhält, damit die Bewegung des Bandes unter den erwähnten Kräften nicht dazu führt, dass sich verschiedene Bandabschnitte untereinander berühren, oder das Band flächig an Stützstrukturen anzuliegen kommt, wodurch der Kühlmittelzutritt gehindert würde. Die beabstandete Anordnung des Bandes ist auch deshalb erforderlich, damit die Gasblasen ungehindert abziehen können. Doch sollte der Abstand nicht zu groß sein, da sonst das Volumen der gesamten Anordnung unnötig groß wird. Ein bevorzugter Abstand ist minimal 10% der Bandbreite, vorzugsweise minimal 40% der Bandbreite.

Mögliche Konfigurationen sind beispielsweise parallel angeordnete gerade Leiterstücke, mäandernde Schleifen, Stapel von solchen, einlagige oder mehrlagige Zylinderspulen, Flachspulen, Stapel von solchen, Kreuzwickelspulen, Yin-Yang-Spulen oder sogar unregelmäßige Knäuel. Die Auswahl der Konfiguration hängt vom Einzelfall ab und erfolgt nach den gegebenen Platzverhältnissen im Gesamtsystem, den Potenzialverhältnissen, dem Konzept für den Abzug der Gasblasen und der Minimierung der Magnetfelder.

Die Bewegungsrichtung des Bandes beim Schalten kann vorherbestimmt werden, wenn das Band in der Anfangsstellung eine Krümmung aufweist, wie bei einer Spule oder Spirale. Dann bewirken Blasenbildung, thermische Längenausdehnung und magnetische Kräfte im Wesentlichen eine Bewegung nach auswärts, so dass sich die Spule oder Spirale etwas öffnet. Auch die thermische Formänderung bewirkt, dass sich die Spule etwas öffnet, falls die Vorderseite des Bandes, die sich beim Schalten schneller erwärmt, innen liegt. Dies ist ohnehin bevorzugt, um die Gefahr der Mikrorissbildung zu minimieren. Die Bewegung ist also stets nach außen gerichtet, wodurch sich der Krümmungsradius vergrößert.

Die freitragenden Strecken zwischen zwei benachbarten Montageelementen können relativ lang gemacht werden, besonders wenn das Band in sich verdrillt und dadurch versteift und gegen Vibrationen geschützt wird. Bevorzugt haben diese Strecken Längen zwischen der 3-fachen bis zur 50-fachen Bandbreite, besonders bevorzugt zwischen der 5-fachen bis zur 30-fachen Bandbreite.

Die gewünschte Konfiguration muss mit Hilfe der vorher beschriebenen Montageelemente erstellt werden. Dazu müssen diese an einer Vorrichtung befestigt werden und bilden mit dieser zusammen die Stützstruktur für das Band. Die Befestigungsvorrichtung besteht vorzugsweise aus isolierendem Material, z. B. Polyimid, GFK oder Keramik, um Kurzschlüsse, Durchschläge und Überschläge zu vermeiden.

Schließlich betrifft ein weiteres Beispiel außerhalb der vorliegenden Erfindung einen Strombegrenzer mit zumindest zwei Begrenzerkomponenten, die jeweils zumindest einen Abschnitt eines Bandleiters aufweisen, der mit einem Hochtemperatursupraleiter beschichtet ist, und mit zumindest einer isolierenden Trennwand zwischen den beiden Begrenzerkomponenten. Die Dicke der Trennwände bemisst sich vorzugsweise nach dem Potenzialunterschied und der Durchschlagfestigkeit des Isoliermaterials, bevorzugt Polycarbonat, Polyester, Polyimid oder GFK. Bevorzugte Formen solcher Trennwände sind wieder Hohlformen, die das flächige Anlegen des Bandes nicht zulassen.

Eine oder mehrere Begrenzerkomponenten in Parallel- oder Reihenschaltung können als Modul mit festem Rahmen zusammengefasst werden. Innerhalb eines Moduls können große Bandlängen untergebracht werden. Das bedeutet einerseits, dass hohe Spannungen auftreten und andererseits, dass beim Schalten große Mengen von Gasblasen im ganzen Modul entstehen, die die Durchschlagfestigkeit der Kühlflüssigkeit stark herabsetzen. Damit wird die Gefahr für Überschläge zwischen verschiedenen Begrenzerkomponenten besonders groß.

Prinzipiell lässt sich das Problem stets durch genügend große Sicherheitsabstände lösen. Im Mittelspannungsbereich sind diese noch akzeptabel, jedoch führen sie im Hochspannungsbereich zu sehr großvolumigen und damit teueren Gesamtsystemen. Dann ist es vorzuziehen, zwischen den einzelnen Komponenten bzw. Modulen Schotten oder Trennwände einzuziehen. Solche Wände bestehen vorzugsweise aus einem Material mit hoher Durchschlagfestigkeit wie z. B. Polyimid, Polycarbonat oder Polyester. Diese haben dann eine noch höhere Durchschlagsfestigkeit als die Kühlflüssigkeit und sie verhindern gleichzeitig, dass sich die Gasblasen zwischen den Komponenten vereinigen können und durchgehende Durchschlagstrecken bilden.

Bevorzugt sind die zumindest zwei Begrenzerkomponenten in eine Kühlflüssigkeit eingetaucht und weisen getrennte Kanäle für den Abzug der Gasblasen auf, die beim Schalten der Abschnitte des Bandleiters in den normalleitenden Zustand entstehen. Die Kanäle sind bevorzugt lang genug, so dass in ihrer Längsrichtung kein Gasdurchschlag mehr auftreten kann. Dann können sie an einen gemeinsamen Behälter angeschlossen werden, in dem z. B. das Gas wieder verflüssigt wird.

Besonders bevorzugt ist es, wenn zumindest zwei Begrenzerkomponenten in Kammern angeordnet sind, die an ihren Unterseiten jeweils zumindest eine Öffnung für den Eintritt der Kühlflüssigkeit aufweisen. Zudem ist es vorteilhaft, durch diese Öffnungen auch die elektrischen Anschlüsse der Komponenten nach unten zu führen und in der Kühlflüssigkeit unterhalb der Kammern zu verschalten. Der Grund ist, dass die beim Schalten entstehenden Gasblasen im Wesentlichen nach oben abziehen, und somit der Raum unterhalb der Kammern weitgehend blasenfrei ist. Dort weist das Kühlmittel also auch beim Schalten noch eine relativ hohe Durchschlagfestigkeit auf. Um die Kühlflüssigkeit unterhalb der Kammern noch besser blasenfrei zu halten, können die Öffnungen vorteilhaft mit einer Blasensperre versehen werden, die einerseits verhindert, dass Blasen aus dem Inneren der Kammern in den Raum unter den Kammern gelangen können, andererseits aber das Kühlmittel im Wesentlichen ungehindert durchlässt. Als solche Blasensperren dienen beispielsweise über die Öffnungen gespannte feine Netze, Gitter, Gewebe, Filze oder Vliese bevorzugt aus isolierendem Material wie Glasfaser, Polyimid, Polyamid oder einem sonstigen Kunststoff.

Besonders bevorzugt ist ferner, wenn Teilbereiche des Bandleiters so angeordnet sind, dass sich die resultierenden Magnetfelder zumindest teilweise gegenseitig kompensieren. Da die einzelnen Bandabschnitte ohnehin beabstandet angeordnet werden, können sich ihre Magnetfelder nicht sehr stark überlappen. Trotzdem wird man bevorzugt Anordnungen wählen, bei denen sich die Magnetfelder der Bandabschnitte, Schleifen oder Windungen gegenseitig kompensieren. Solche Anordnungen sind beispielsweise Stapel von Flachspulen mit gegenläufigem Stromfluss der einzelnen Spulen oder Lagenspulen mit gegenläufigem Stromfluss der einzelnen Lagen oder Stapel von Mäandern mit Umkehrschleifen.

Schließlich ist es vorteilhaft, wenn der Bandleiter in den oben erläuterten Ausführungsformen des Strombegrenzers nach dem Schalten in den normalleitenden Bereichen eine Flächenleistungsdichte von mindestens 50 kW/m$^2$, besonders bevorzugt von mindestens 250 kW/m$^2$ entwickelt. Damit wird sichergestellt, dass beim Schaltvorgang ein hinreichender Spannungsabfall längs des Bandleiters auftritt.

## 4. Kurze Beschreibung der Zeichnungen

Im Folgenden werden bevorzugte Ausführungsbeispiele der Erfindung unter Bezugnahme auf die folgende begleitenden Figuren näher erläutert:

Fig. 1:        Prinzip der Halterung oder Führung des Bandleiters durch konkave Hohlformen;
Fig. 2        Prinzip der Fixierung eines Bandleiters durch kontaktierende Montageelemente;
Fig. 3:        Prinzip der freitragenden Halterung des Bandleiters (in Aufsicht);
Fig. 4a-f:    Beispielhafte Ausführungsformen für konkave Hohlformen;
Fig. 5:        Beispielhaftes doppelseitiges Montageelement;
Fig. 6a- d:    Beidseitige Halterung des Bandleiters durch alternierende oder paarweise Anordnung von Montageelementen oder durch Ösen;
Fig. 7:        Spiralschlauch als Montageelement;
Fig. 8:        Flachspule aus Bandleiter;
Fig. 9:        Einlagige Zylinderspule aus Bandleiter;
Fig. 10a-d:    Mäanderförmige Bandleiteranordnungen;
Fig. 11a, b:    Bandleiter um zwei Pfosten gewickelt;
Fig. 12:        Yin - Yang- oder Baseball- Spule; und
Fig. 13:        Abschottung der Komponenten bei hohen Spannungen.

## 5. Detaillierte Beschreibung bevorzugter Ausführungsformen

Im Folgenden werden gegenwärtig bevorzugte Ausfiihrungsbeispiele der Erfindung näher beschrieben. Dabei werden folgende Definitionen verwendet:

| | |
|---|---|
| HTS: | Hochtemperatur-Supraleiter, hier in Form von Dünnschichten |
| CC: | coated conductor, HTS-beschichtetes Metallband |
| FSB: | Fehlerstrombegrenzer |
| Bandleiter: | hier synonym zu CC |
| Hauptflächen: | die mit HTS beschichtete Fläche des CC oder die dieser gegenüberliegende Fläche |
| Bandränder: | Seitenfläche am Rand des Bandes inklusive der Bandkanten und etwaiger unbeschichteter Randstreifen des Bandes |
| Vorderseite: | mit HTS beschichtete Hauptfläche (falls einseitig HTS-beschichtet) |
| Rückseite: | Hauptfläche ohne HTS-Schicht (falls einseitig HTS-beschichtet) |
| Bandabschnitte: | verschiedene Teile des Bandes, die sich gegenseitig berühren oder stören können |

| Thermische Formänderung: | elastische oder plastische Verbiegung des Bandes, verursacht durch unterschiedliche thermische Ausdehnung der Vorder-und Rückseite des Bandes auf Grund von Temperaturunterschieden (ähnlich Bimetall). |
| Stützstruktur: | Vorrichtung zur mechanischen Verbindung des Bandes mit einem festen Rahmen (z. B. Modul oder Kryostat, s. u.) |
| Montageelement: | der Teil der Stützstruktur, der unmittelbar mit einem Band in Berührung steht |
| Befestigungsvorrichtung: | restlicher Teil der Stützstruktur, verbindet die Montageelemente mit einem festen Rahmen |
| Begrenzerkomponente | kleinste Einheit eines Bandes oder mehrerer verbundener Bänder mit einer Stützstruktur |
| Modul: | ein oder mehrere Begrenzerkomponenten, die in einem festen Rahmen zusammengefasst sind |
| CC-FSB: | ein oder mehrere Module, die in einem Kryostaten zusammengefasst sind, bilden zusammen den Strombegrenzer |
| Gesamtsystem: | ein oder mehrere Kryostaten (z. B. für jede Drehstrom-Phase) inklusive der Kühlmaschinen, sowie der Mess-, Regel- und Schalteinrichtungen |
| GFK: | Glasfaser-verstärkter Kunststoff |

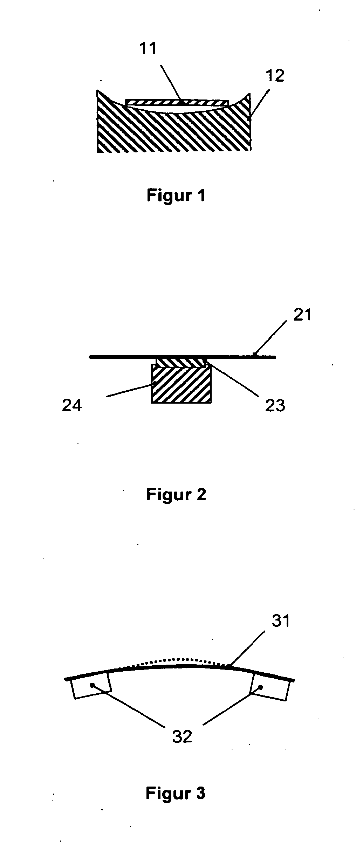

Ein wichtiger Aspekt der vorliegenden Erfindung basiert darauf, den Bandleiter an seinen Rändern zu fixieren.Der Leiter hat dadurch einen kontrollierten Bewegungsspielraum in der Halterung. Zwischen den Montageelementen verläuft das Band, bevorzugt auf einem Großteil seiner Länge, freitragend. Infolge der Randhalterung werden bevorzugt konkave Montageelemente verwendet, so dass die Hauptflächen des Bandleiters selbst bei Bewegung nicht in flächigen Kontakt zu benachbarten Strukturen kommen können. Das Prinzip ist in Fig. 1 dargestellt. Dabei kann das Band 11 mit Hilfe des Montageelements 12 stehend oder liegend oder in jeder anderen Lage eingebaut werden.

Das hier nur zur Erläuterung angegebene Prinzip der kontaktierenden Fixierung ist in Fig. 2 wiedergegeben. Der Bandleiter 21 ist bevorzugt über ein flächiges metallisches Überbrückungsteil 23 mit einem Stützteil 24 verbunden das seinerseits an der Befestigungsvorrichtung (nicht dargestellt) montiert ist. Möglich ist aber auch, nur ein Teil 23 zu verwenden, das direkt an der Befestigungsvorrichtung montiert ist.

Das Band muss sich, besonders bei fester Montage, während der Erwärmung ausdehnen können, ohne zu knicken oder zu verbiegen. Dies wird dadurch erreicht, dass es zwischen jeweils zwei festen Montageelementen Freiheitsgrade zur Bewegung hat. Vorteilhaft ist dabei insbesondere, wenn der Bandleiter nicht geradlinig verläuft, sondern stets einen gewissen Bogen aufweist. Dann kann die Längenausdehnung durch eine elastische Wölbung ausgeglichen werden: Dieses Prinzip ist in Fig. 3 veranschaulicht.

Im Folgenden sollen beispielhafte Lösungen zur Montage des Bandleiters vorgestellt werden, die diesen Konstruktionsprinzipien Rechnung tragen.

Montageelemente zur Halterung am Rand des Bandes

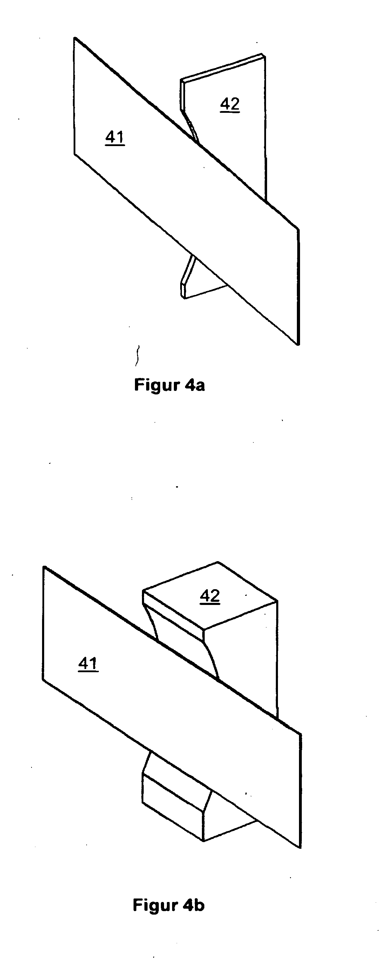

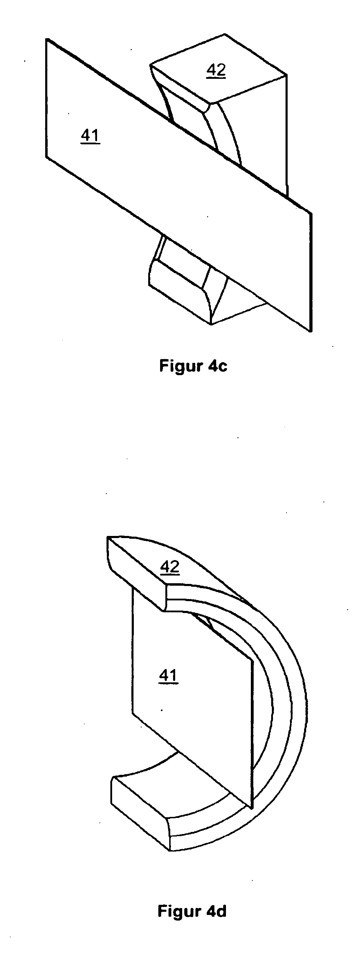

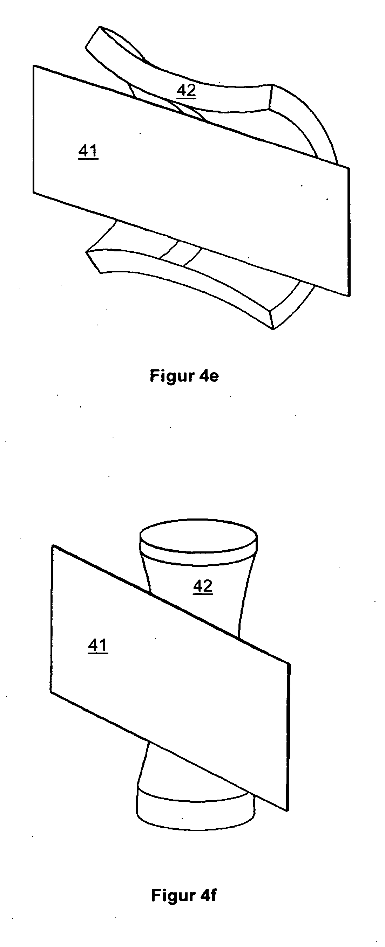

In Längsrichtung des Bandes gibt es verschiedene bevorzugte Formen, z. B. dünne Laschen (Fig. 4a), dickere Platten, auch mit abgerundeten Kanten (Fig. 4b, 4c), gerade Rohrstücke (Fig. 4d) oder solche mit trompetenförmigen Ansätzen (Fig. 4e) oder runde Pfosten (Fig. 4f). Beim trompetenförmigen Auslauf ist der Krümmungsradius der Trompeten größer oder gleich dem minimal zulässigen Krümmungsradius des Bandes. Dadurch wird dieses gegen unzulässige Verbiegungen zusätzlich geschützt.

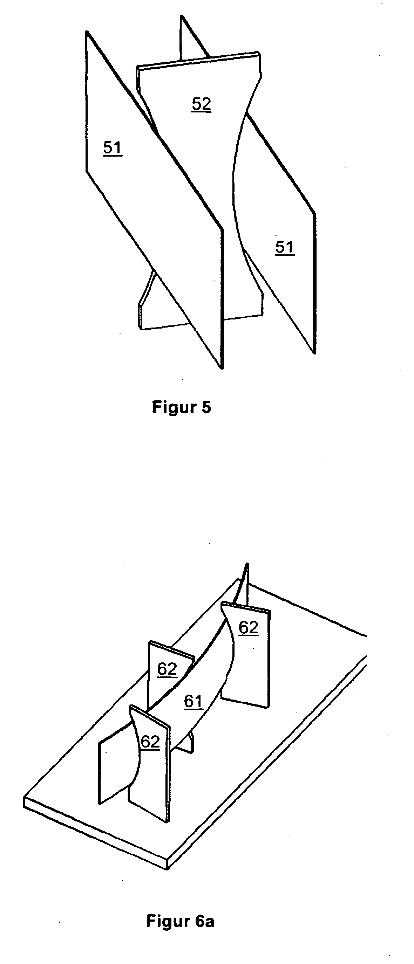

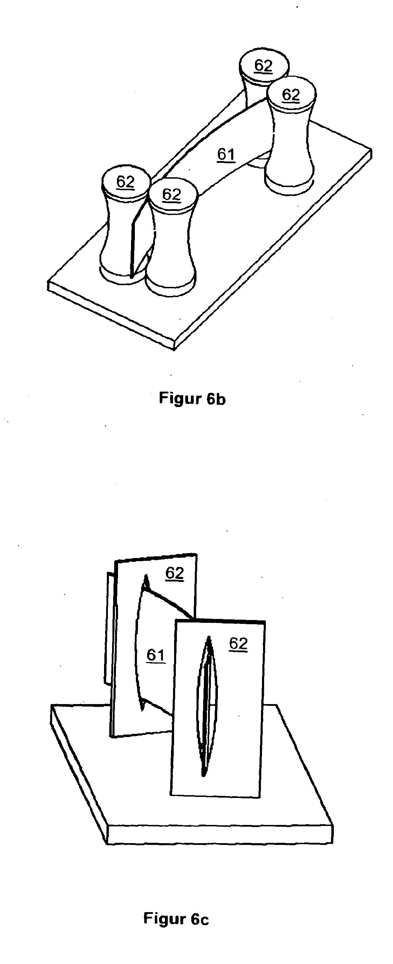

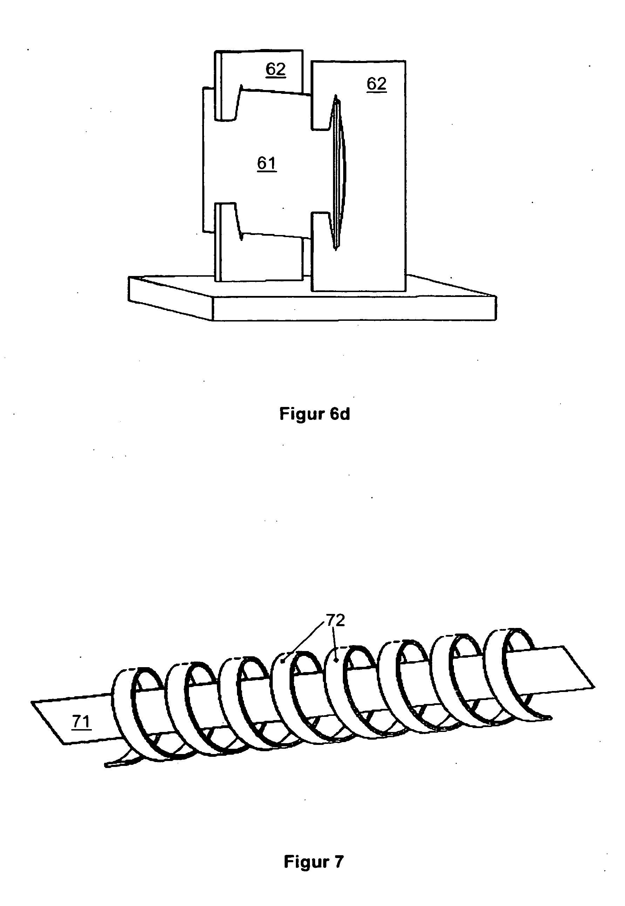

Alle Elemente können zweiseitig ausgeführt werden, so dass auf beiden Seiten ein Band gehalten wird. Dies ist in Fig. 5 am Beispiel der Lasche 52 gezeigt. Durch die bisher beschriebenen Elemente wird das Band jeweils nur auf einer Seite gehalten. Zur beidseitigen Halterung des Bandes müssen solche Elemente auf beiden Seiten angeordnet werden. Bevorzugte Anordnungen sind alternierende (Fig. 6a) oder paarweise Anordnungen (Fig. 6b), wobei das Paar auch wie in Fig. 6c gezeigt in eine einzige Stütze integriert werden kann, so dass sich eine Öse ergibt. Ist die Öse nicht geschlossen, sondern hat eine Öffnung wie in Fig. 6d und besteht aus hinreichend flexiblem Material, so kann das Band von der Seite her eingesetzt werden, was den Zusammenbau erleichtert. Im Falle einer ringförmigen Halterung oder einer geschlossenen Öse, kann auch ein schmaler Schnitt angebracht werden, der das Einschieben des Bandleiters gestattet.

Eine weitere bevorzugte Form gemäß dem Grundprinzip der Randhalterung, mit offenem Kühlmittelzutritt und mit beidseitiger Halterung ist ein elastischer Spiralschlauch 72 aus Kunststoff wie in Fig. 7 dargestellt. Dieser lässt sich vielseitig zu Wicklungen verarbeiten oder auch als Isolierung für freitragende Bandabschnitte einsetzen. Gleiches gilt auch für elastische Kunststoffspiralen und runde Kunststofflcämme, wie sie als Binderücken für Broschüren bekannt sind. Besonders Kunststoffkämme sind vorteilhaft, da das Band seitlich eingeschoben werden kann.

*Montage mit und ohne Spiel*

Umfassen die konkaven Montageelemente wie in den Fig. 4-7 das Band nur lose, so hat dieses noch ein gewisses Spiel und kann sich in seiner Längsrichtung verschieben und in eingeschränktem Maße seine Richtung ändern, um den auf das Band wirkenden Kräften auszuweichen. Dadurch werden stärkere Deformationen, die das Band beschädigen würden, vermieden. Grundsätzlich eignen sich einige Ausführungen aber auch zu einer relativ festen Montage des Bandes. Dafür kommt die paarweise Anordnung der Elemente oder die Ösenform in Frage, wobei die Passung zwischen Band und Montageelementen so eingestellt werden muss, dass das Band zwar eingeklemmt aber noch nicht beschädigt wird. Dazu bietet sich eine federnde Passung an.

*Kontaktierende Montageelemente*

**[0050]** - Bei einem außerhalb der vorliegenden Erfindung befindlichen Beispiel kann der Kontakt zwischen Band 21 und dem Überbrückungsteil 23 in Fig. 2 vorzugsweise durch Klammern, niedrig schmelzende Lote, z. B. auf Indium-, Wismut- oder Zinnbasis, Presskontakte, Leitsilberpaste oder Leitkleber, z.B. auf Epoxidharzbasis mit Silberfüllung, hergestellt werden. Bevorzugt sind Presskontakte, wobei als Einlage eine Folie aus weichem Metall, z. B. Indium, Blei oder Kupfer, verwendet wird, die bevorzugt um das Band gewickelt ist. Ebenfalls bevorzugt sind Leitkleber, z. B. auf Epoxidharzbasis mit Silberfüllung. Unter Epoxidharzen besonders bevorzugt sind kalthärtende 2-Komponenten-Epoxidharze, da sie die besten Tieftemperatureigenschaften besitzen.

Das Stützteil 24 ist mit dem Überbrückungsteil 23 normalerweise fest verbunden (z. B. durch Kleben, Schrauben, Nieten, Löten oder Klemmen). Es ist aber auch möglich, eine Verbindung mit Spiel vorzusehen. Auch freitragende Überbrückungsteile kommen in Betracht, wenn es sich lediglich um die Überbrückung einer Schadstelle des Bandes handelt.

*Anordnung des Bandes*

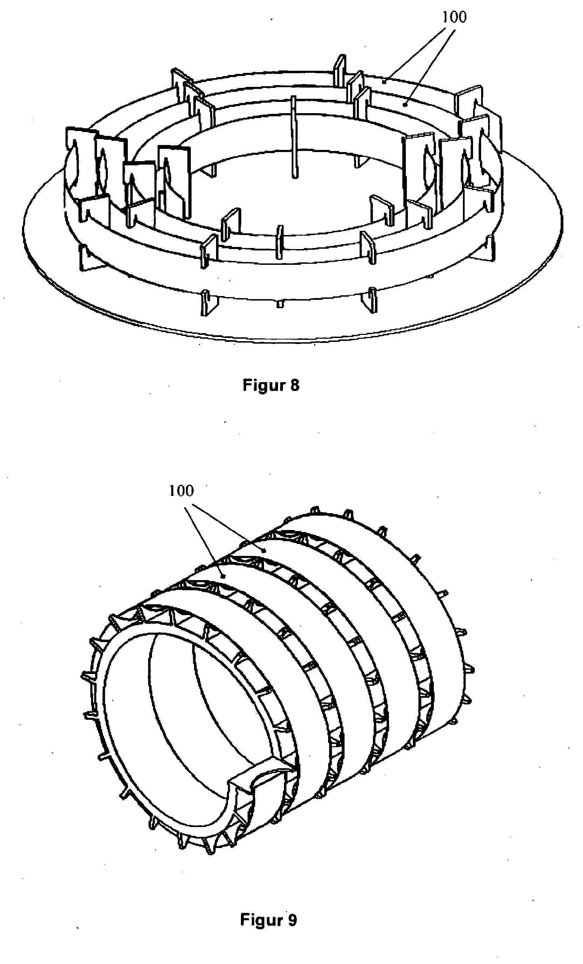

Bevorzugte Ausführungsformen von Bandanordnungen für Begrenzerkomponenten sind in Fig. 8 - 12 beispielhaft dargestellt. Bei allen Ausführungsformen muss der oben angegebene bevorzugte Mindestradius beachtet werden.

Fig. 8 zeigt z. B. eine Flachspule, die mit offenen Ösen als Montageelemente auf einer Platte aus Isoliermaterial als Befestigungsvorrichtung angeordnet ist. Ebenso kommen alle anderen Montageelemente in Frage. Die hier gezeigte Flachspule hat die Form einer Kreisscheibe. Andere Beispiele sind ovale Spulen oder viereckige mit abgerundeten Ecken. Flachspulen können aufeinander gestapelt werden. Dabei verschaltet man sie bevorzugt so, dass der Stromfluss jeweils gegenläufig erfolgt, um möglichst geringes Eigenmagnetfeld und geringe Induktivität zu erhalten.

Fig. 9 zeigt eine einlagige Zylinderspule. Das Band liegt einseitig auf Laschen, die an einem Rohr befestigt sind. Zylinderspulen mit abgestuften Durchmessern können ineinander gestellt werden, so dass sich eine mehrlagige Spule ergibt. Die einzelnen Lagen verschaltet man wieder bevorzugt so, dass der Stromfluss gegenläufig ist und die Magnetfelder sich kompensieren.

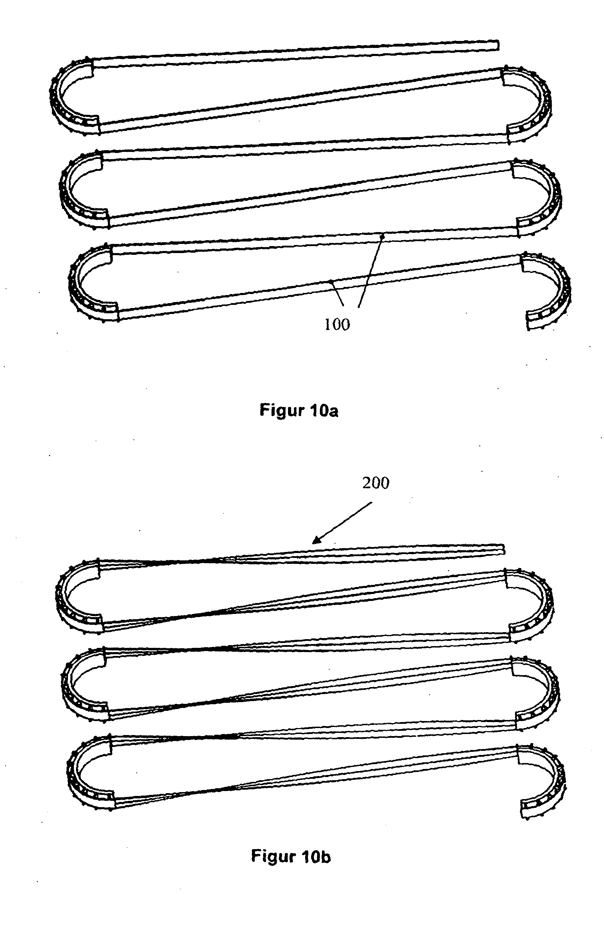

Fig. 10a und 10b zeigen einlagige Mäander, bei denen die Kurven des Bandes von Laschen gehalten werden, die an kurzen Halbrohren befestigt sind. In Fig. 10b ist das Band auf den freitragenden geraden Strecken 200 jeweils um 180° verdrillt. Dies ist vorteilhaft, da dann die Vorderseite des Bandes stets in der Innenkurve liegt und somit der Supraleiter gestaucht wird. Darüber hinaus dient das Verdrillen der mechanischen Stabilisierung des Bandes, insbesondere gegen Schwingungen. Beim Verdrillen werden die Ränder des Bandes gedehnt und die Mittelachse des Bandes gestaucht. Dabei darf die maximal zulässige Deformation $\varepsilon_{max}$ des Bandes nicht überschritten werden. Eine Rechnung ergibt als minimal zulässige Ganghöhe $h_{min} = \dfrac{\pi \cdot b/2}{\sqrt{\varepsilon_{max}}}$, wobei b die Bandbreite ist. Beispielsweise wird mit b = 10

mm und $\varepsilon_{max}$ = 0,2% die minimale Ganghöhe etwa 350 mm, entsprechend einer freien Länge von 175 mm bei 180° Verdrillung. Diese Formel hat sich in der Praxis bewährt.

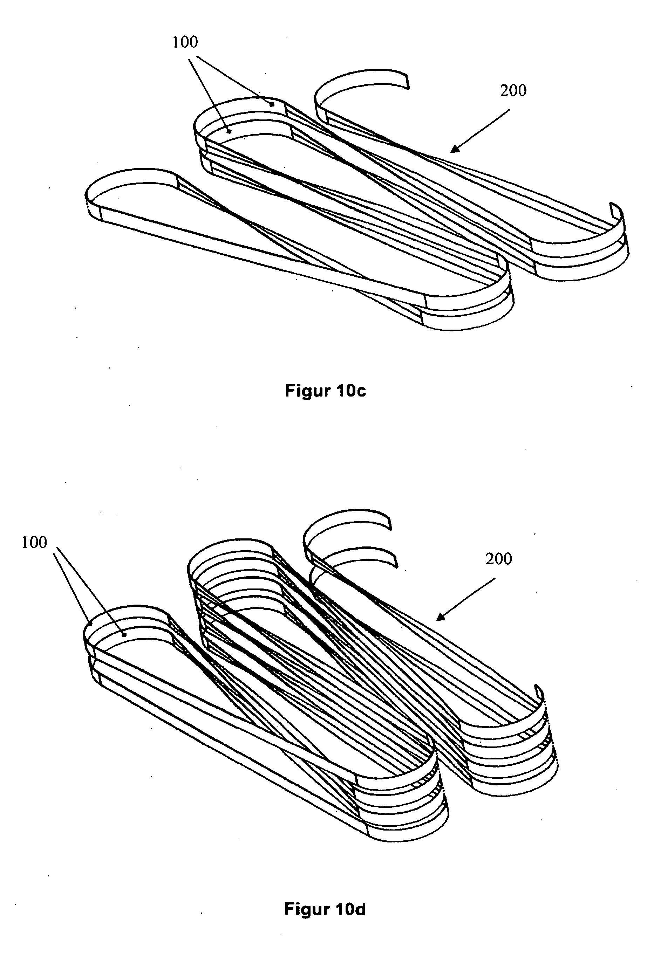

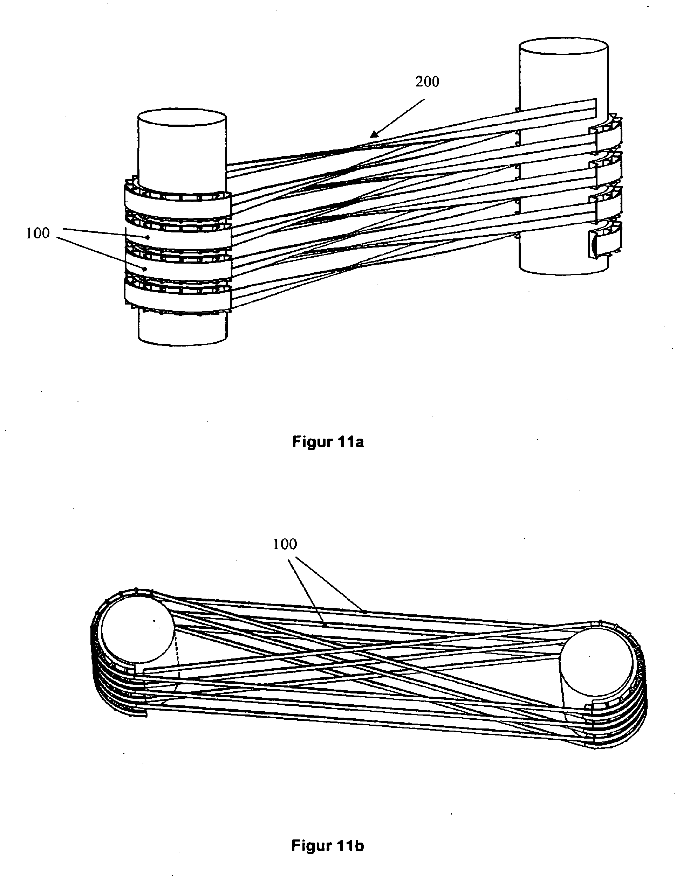

Mäander können aufeinander gestapelt werden. Fig. 10c zeigt zwei Lagen eines Mäanderstapels. Die Pfosten sind hier nicht gezeichnet. Zwischen den beiden Lagen befindet sich eine unverschränkte Umkehrschleife. So kommt die Vorderseite des Bandes immer nach innen und zudem ist der Strom in beiden Lagen gegenläufig. Letzteres gilt jedoch nicht für die Umkehrschleife. Um zwei gegenläufige Umkehrschleifen zu erhalten, sind mindestens 4 Lagen des Mäanderstapels erforderlich. Wie diese anzuordnen sind, zeigt Fig. 10d. Für einen flachen und kompakten Aufbau kann ferner das Band um zwei Pfosten gewickelt werden. Das Ergebnis ist in Fig. 11 a dargestellt. Durch das Verdrillen können sich die Wicklungen in der Mitte berührungslos überkreuzen und die Vorderseite liegt immer innen. Die Magnetfelder kompensieren sich noch besser, und die Isolationsabstände werden größer, wenn die Überkreuzungen nur alternierend erfolgen, wie in Fig. 11b gezeigt. Allerdings sollten entgegen der Figur die überkreuzenden Bandabschnitte wiederum verdrillt sein, damit die Vorderseite des Bandes immer innen liegt.

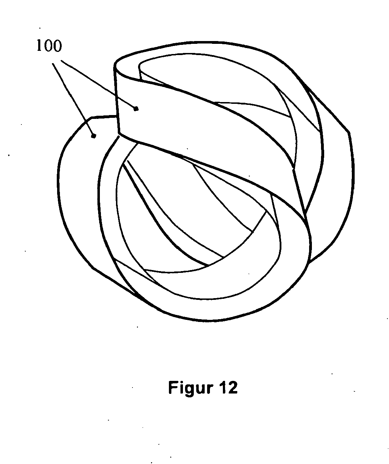

Eine weitere bevorzugte Anordnung mit geringem Eigenmagnetfeld ist die so genannte Yin-Yang-Spule (baseball coil), wie in Fig. 12 dargestellt.

In den Ausführungsbeispielen der Figuren 8-12 weisen benachbarte Bandabschnitte 100 immer einen Abstand von mehr als 10 %, vorzugsweise mehr als 40% der Breite des Bandleiters auf. Dadurch wird verhindert, das beim Schalten vom supraleitenden in den normalleitenden Zustand und der damit verbundenen Erwärmung die Blasenentwicklung des umgebenden Kühlmittels zu einer übermäßigen Deformation des Bandleiters führt. Mit den angegebenen Werten für den Mindestabstand ist sichergestellt, dass die Blasen im Wesentlichen ungehindert entweichen können.

*Abführung der Gasblasen*

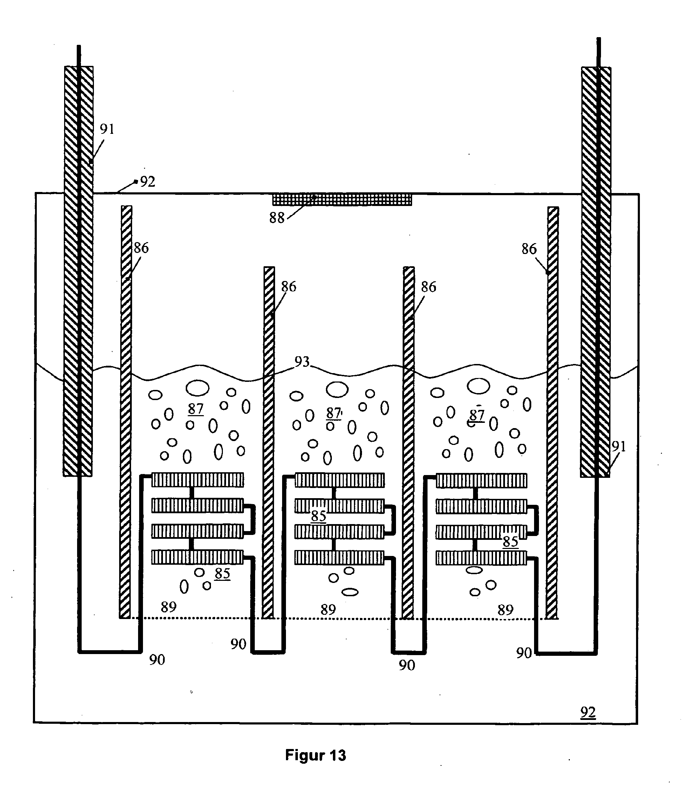

[0059]   - Bei Verwendung des Strombegrenzes nach Anspruch 1 im Hochspannungsbereich, möglicherweise auch schon im Mittelspannungsbereich sind Trennwände zur Abschottung von Komponenten auf stark verschiedenem Potenzial vorteilhaft, um große Sicherheitsabstände überflüssig zu machen und so den FSB deutlich Platz und Kosten sparender zu bauen. Fig. 13 zeigt eine bevorzugte Anordnung. Hier sind beispielhaft drei Begrenzerkomponenten 85 bestehend aus Flachspulenstapeln gezeigt. Jede Komponente 85 befindet sich in einer aus Trennwänden 86 gebildeten Kammer, die bevorzugt nach oben hin verlängert ist und dort als Blasenkamin 87 dient, der in einen gemeinsamen Gasbehälter mit Kühlfläche 88 führt. Die Blasenkamine müssen so lang gewählt werden, dass Überschläge im Gas ausgeschlossen sind. An den Gasbehälter angeschlossen ist bevorzugt noch ein Druckausgleichsbehälter (nicht gezeichnet).

An der Unterseite jeder Kammer ist ein Netz 89 als Blasensperre gespannt. Dadurch befindet sich die Verschaltung 90 der Komponenten untereinander in der blasenfreien Kühlflüssigkeit mit hoher Durchschlagfestigkeit unterhalb der Kammern. Dort enden auch die Stromzuführungen 91, die in extra abgeschotteten Kammern geführt werden und im Bereich der Kühlflüssigkeit aus Hochtemperatursupraleitermaterial bestehen können, um keine unnötigen Verluste zu verursachen. Die gesamte Anordnung befindet sich in einem festen Rahmen 92, der in Fig. 13 beispielsweise als Kryostat gezeichnet ist und das Kühlmittel 93 enthält.

Bezugszeichenliste:

Bandleiter (CC): 11, 21, 31, 41, 51, 61, 71
Montageelement: 12, 32, 42, 52, 62, 72
Überbrückungsteil: 23
Stützteil: 24
Begrenzerkomponenten: 85
Trennwände: 86
Blasenkamin mit Gasblasen: 87
Kühlfläche: 88
Netz als Blasensperre: 89
Verschaltung: 90
Stromzuführungen mit Isolatoren: 91
Kryostaten- oder Modulwand: 92
Kühlflüssigkeitsspiegel: 93
Benachbarte Bandabschnitte: 100
Gerader Bandbereich mit Verdrillung: 200

**Patentansprüche**

1.  Strombegrenzer mit

    a. einem Bandleiter (11, 41, 51, 61, 71), der mit einem Hochtemperatursupraleiter beschichtet ist;

    b. zumindest einem Montageelement (12, 42, 52, 62, 72), das den Bandleiter (11, 41, 51, 61, 71), im Wesentlichen ausschließlich an einem oder mehreren Randbereichen hält, so dass der Bandleiter das Montageelement nicht flächig kontaktieren kann, **dadurch gekennzeichnet, dass**

    c. das Montageelement (12, 42, 52, 62, 72) eine Hohlform umfasst und sich der Bandleiter (11, 41, 51, 61, 71) in der Hohlform erstreckt.

2. Strombegrenzer nach Anspruch 1, wobei die Hohlform des Montageelements (12, 42, 52, 62, 72) auf einer dem Bandleiter (11, 41, 51, 61, 71), zugewandten Seite einen zumindest abschnittsweise konkaven Querschnitt aufweist.

3. Strombegrenzer nach Anspruch 2, wobei der Bandleiter (11, 41, 51, 61, 71), eine Breite d aufweist und wobei die Hohlform einen mittleren Krümmungsradius r aufweist mit $0,5d \le r \le 10d$, bevorzugt $0,6d \le r \le 4d$.

4. Strombegrenzer nach einem der Ansprüche 1 bis 3, wobei das Montageelement als eine Aussparung (42) oder Öffnung (62) in einer Platte oder als Rohr (42) mit rundem oder ovalem Querschnitt ausgebildet ist, durch die / das sich zumindest ein Abschnitt des Bandleiters (41) erstreckt.

5. Strombegrenzer nach einem der vorhergehenden Ansprüche, wobei der Bandleiter durch das Montageelement in seinen Randbereichen mit einem Spiel gehalten wird, das vorzugsweise zwischen 5% und 50% und besonders bevorzugt zwischen 10% und 30% der Breite d des Bandleiters beträgt.

6. Strombegrenzer nach einem der vorhergehenden Ansprüche, wobei das Montageelement eine federnde Passung für den Bandleiter aufweist.

7. Strombegrenzer nach einem der vorhergehenden Ansprüche

d. wobei der Bandleiter (11, 41, 51, 61, 71) zumindest einen Bereich mit zumindest zwei benachbarten Bandabschnitten (100) aufweist; und
e. wobei die benachbarten Bandabschnitte (100) des Bandleiters (11, 41, 51, 61, 71) einen Abstand voneinander von mehr als 10%, vorzugsweise mehr als 40% der Bandbreite des Bandleiters (11, 41, 51, 61, 71) aufweisen.

8. Strombegrenzer nach Anspruch 7, wobei der Bandleiter (11,41,51,61,71) eine spulen-, spiral- und / oder mäanderförmige Konfiguration aufweist.

**Claims**

1. Current limiter comprising

a. a tape conductor (11, 41, 51, 61, 71) coated with a high temperature superconductor;
b. at least one mounting element (12, 42, 52, 62, 72) which holds the tape conductor (11, 41, 51, 61, 71) which is essentially holding the conductor tape solely on one or more edge regions in such a way that the principal surfaces of the tape cannot get in touch with the mounting element, **characterized in that**
c. the mounting element (12, 42, 52, 62, 72) comprises a hollow form, and the tape conductor (11, 41, 51, 61, 71) extends inside the hollow form.

2. Current limiter according to claim 1, wherein the hollow form of the mounting element (12, 42, 52, 62, 72) comprises on a side facing the tape conductor (11, 41, 51, 61, 71) at least one section of concave cross section.

3. Current limiter according to claim 2, wherein the tape conductor (11, 41, 51, 61, 71) has a width d, and wherein the hollow form has an average radius of curvature r with $0.5d \le r \le 10d$, preferably $0.6d \le r \le 4d$.

4. Current limiter according to one of the previous claims 1 - 3, wherein the mounting element is formed as a recess (42) or aperture (62) in a plate, or as a tube (42) having a circular or oval cross section, through which at least one section of the conductor tape (41) extends.

5. Current limiter according to one of the previous claims, wherein the tape conductor is held at its edge regions by the mounting element with a play implying a clearance of preferably between 5% and 50%, and particularly preferably between 10% and 30% of the width d of the tape conductor.

6. Current limiter according to one of the previous claims, wherein the mounting element has a spring loaded fit for the tape conductor.

**7.** Current limiter according to one of the previous claims

> d. wherein the tape conductor (11, 41, 51, 61, 71) has at least one region with at least two neighbouring tape sections (100); and
> e. wherein the neighbouring tape conductor sections (100) of the tape conductor (11, 41, 51, 61, 71) have a distance from each other of more than 10%, preferably more than 40% of the tape width of the tape conductor (11, 41, 51, 61, 71).

**8.** Current limiter according to claim 7, wherein the tape conductor (11, 41, 51, 61, 71) has a coil-, a spiral-, and / or a meander-like configuration.


**Revendications**

**1.** Limiteur de courant comprenant

> a. un conducteur-ruban (11, 41, 51, 61, 71) revêtu d'un supraconducteur à haute température ;
> b. au moins un élément de montage (12, 42, 52, 62, 72) qui ne maintient le conducteur-ruban (11, 41, 51, 61, 71) sensiblement que dans une ou plusieurs zones de bords, de sorte quel le conducteur-ruban ne peut pas être en contact à plat avec l'élément de montage, **caractérisé en ce que**
> c. l'élément de montage (12, 42, 52, 62, 72) présente une forme creuse et le conducteur-ruban (11, 41, 51, 61, 71) s'étend dans la forme creuse.

**2.** Limiteur de courant selon la revendication 1, la forme creuse de l'élément de montage (12, 42, 52, 62, 72) présentant, sur un côté tourné vers le conducteur-ruban (11, 41, 51, 61, 71), une section transversale concave au moins par endroits.

**3.** Limiteur de courant selon la revendication 2, le conducteur-ruban (11, 41, 51, 61, 71) présentant une largeur d, et la forme creuse présentant un rayon de courbure moyen où $0,5d \leq r \leq 10d$, de préférence $0,6d \leq r \leq 4d$.

**4.** Limiteur de courant selon une des revendications 1 à 3, l'élément de montage étant conformé en un évidement (42) ou une ouverture (62) dans une plaque ou en un tube (42) à section ronde ou ovale, que traverse au moins une portion du conducteur-ruban (41).

**5.** Limiteur de courant selon une des revendications précédentes, le conducteur-ruban étant maintenu par l'élément de montage, au niveau de ses zones de bords, avec un jeu qui est compris, de préférence, entre 5 % et 50 % et, selon une préférence particulière, entre 10 % et 30 % de la largeur du conducteur-ruban.

**6.** Limiteur de courant selon une des revendications précédentes, l'élément de montage comportant un moyen d'assemblage élastique pour le conducteur-ruban.

**7.** Limiteur de courant selon une des revendications précédentes,

> d. le conducteur-ruban (11, 41, 51, 61, 71) comportant au moins une zone avec au moins deux portions de bande voisines (100) ; et
> e. les portions de bande voisines (100) du conducteur-ruban (11, 41, 51, 61, 71) présentant un écartement mutuel supérieur à 10 %, de préférence supérieur à 40 % de la largeur de bande du conducteur-ruban (11, 41, 51, 61, 71).

**8.** Limiteur de courant selon la revendication 7, le conducteur-ruban (11, 41, 51, 61, 71) présentant une configuration en bobine, en spirale et/ou à méandres.

11

12

**Figur 1**

21

24
23

**Figur 2**

31

32

**Figur 3**

**Figur 4a**

**Figur 4b**

**Figur 4c**

**Figur 4d**

**Figur 4e**

**Figur 4f**

**Figur 5**

**Figur 6a**

**Figur 6b**

**Figur 6c**

**Figur 6d**

**Figur 7**

100

**Figur 8**

100

**Figur 9**

100

**Figur 10a**

200

**Figur 10b**

100

200

**Figur 10c**

100

200

**Figur 10d**

**Figur 11a**

**Figur 11b**

100

**Figur 12**

**Figur 13**

**IN DER BESCHREIBUNG AUFGEFÜHRTE DOKUMENTE**

**In der Beschreibung aufgeführte Patentdokumente**

- DE 19939066
- DE 19827225
- DE 19836860
- EP 1042820 A
- DE 10225935
- WO 2004006345 A2

- EP 0503448 A2
- EP 0444702 A2
- EP 0385485 A2
- EP 1217666 A
- DE 19720397
- EP 0935261 A